# EUROPÄISCHE PATENTSCHRIFT

(11) **EP 1 041 169 B1**
(45) Veröffentlichungstag und Bekanntmachung des Hinweises auf die Patenterteilung: **26.09.2007**
(21) Anmeldenummer: 99106375.1
(22) Anmeldetag: 29.03.1999
(51) Int. Cl.: C23C 14/24

(54) **Vorrichtung und Verfahren zur Beschichtung von Substraten durch Aufdampfen mittels eines PVD-Verfahrens**
Apparatus and method for coating substrates by a PVD process
Dispositif et procédé pour revêtir des substrats par un procédé PVD

(43) Veröffentlichungstag der Anmeldung: 04.10.2000
(73) Patentinhaber: ANTEC Solar Energy AG, 60311 Frankfurt am Main (DE)
(72) Erfinder: Gegenwart, Rainer Dr., 63322 Rödermark (DE); Richter, Hilmar Dr., 61194 Niddatal-Assenheim (DE)
(74) Vertreter: Englaender, Klaus

(56) Entgegenhaltungen:
- EP-A- 0 535 522
- WO-A-91/04348
- DE-A- 2 436 431
- DE-A- 2 653 909
- US-A- 5 532 102

## Beschreibung

Die Erfindung betrifft eine Vorrichtung und ein Verfahren zur Beschichtung von Substraten unit CdS- und CdTe-Schichten durch Aufdampfen mittels des CSS(Close Spaced Sublimation)-Verfahrens.

Zur industriellen Beschichtung auch von großflächigen Elektronikbauteilen mit Halbleitern, insbesondere Silizium, oder mit Dielektrika wie SiO₂, Si₃N₄ werden CVD-Verfahren eingesetzt. Entsprechende Vorrichtungen für die Massenproduktion sind bekannt.

Hingegen sind für die Herstellung von z.B. Elektrolumineszenz-Displays oder bestimmten Solarzellen wie CdS/CdTe-Solarzellen PVD-Verfahren geeignet, die eine Beschichtung durch Aufdampfen von Material aus einer aufgeheizten Quelle vorsehen. Neben thermischen Verdampfern z.B. in der Großflächenelektronik (beispielsweise für die Herstellung von Displays) wird für CdS/CdTe-Solarzellen speziell die CSS-Technik angewandt. Allerdings sind die bisher bekannten Vorrichtungen weder von ihren Abmessungen noch ihrem Materialvorrat her für eine kontinuierliche Fertigung von größeren Modulen geeignet.

Der Erfindung liegt die Aufgabe zugrunde, eine Vorrichtung und ein Verfahren zur Beschichtung von Substraten zu Schaffen, so daß eine großflächige, möglichst kontinuierliche Beschichtung speziell für CdS/CdTe-Solarzellen möglich ist.

Diese Aufgabe wird durch den Gegenstand des Anspruchs 1 bzw. dem Gegenstand des Anspruch 10, gelöst. Vorteilhafte Weiterbildungen sind in den Unteransprüchen definiert.

Bei der Skalierung einer CSS-Vorrichtung auf Produktionsmaßstäbe mit großen Beschichtungsflächen und hohem Durchsatz muß dafür gesorgt werden, daß die Vorrichtung im Durchlaufverfahren betreibbar ist. Die Möglichkeit des Einsatzes mehrerer Verdampferquellen wurde wegen des hohen konstruktiven Aufwandes und der Problematik der Einstellung gleicher Beschichtungsbedingungen über alle Quellen verworfen. Ferner wurde auch verworfen, großvolumige Behälter einzusetzen und deren Temperatur während der Beschichtung zu verändern, um füllstandsabhängige Beschichtungsratenänderungen auszugleichen. Solche Temperaturänderungen verbieten sich, da hierdurch auch die Schichtbildung auf dem Substrat beeinflußt wird.

Durch die im Anspruch 1 angegebene Lösung ist es hingegen möglich, eine großflächige Verdampfer- oder Sublimationsquelle einzusetzen, die einen ausreichend hohen Materialvorrat für eine lange Standzeit der Quelle gestattet, ohne daß füllstandsabhängige ausgleichende Maßnahmen vorgenommen oder der Materialvorrat nachgefüllt werden müßte. Dies wird dadurch erreicht, daß die nach der Erfindung vorgesehene Abdeckung den Beschichtungsprozeß vom Materialvorrat entkoppelt. Durch die erhöhte Temperatur der Abdeckung "sieht" das Substrat nicht mehr wie bei den bisherigen CSS-Vorrichtungen den Materialvorrat, sondern die Abdeckung als Verdampfer- bzw. Sublimationsquelle, die damit als physikalische Beschichtungsquelle wirkt und das thermische und kinetische Verhalten der verdampften bzw. sublimierten Materialien bestimmt. Damit sorgt die Abdekkung für eine räumliche und physikalische Trennung des Materialvorrats vom Substrat.

Auf diese Weise ist vermieden, daß sich Verteilung und Rate der Beschichtung mit sinkendem Füllstand im Materialbehälter ändern.

Es ist zwar seit mehr als 25 Jahren bekannt, z.B. Verdampfungsbehälter für Selen mit gelochten Abdeckungen zu versehen, jedoch zu dem Zweck, die Verdampfungswolke einer thermischen Verdampferquelle mit Hilfe eines gelochten Bleches in einen gleichmäßigen und reproduzierbaren Dampfstrom auf ein Substrat zu lenken und zu verteilen. So werden seit etlichen Jahren Substratbeschichtungen mit Selen zur Herstellung von elektronischen und optischen Bauelementen im CVD-Verfahren vorgenommen. Das Selen wird in einem Materialbehälter verdampft und trifft aus dem Verdampfungsbehälter auf das zu beschichtende Material. Da die Verdampfung und der Dampfaustritt aus den Behältern in der Regel ungleichmäßig sind, hat man die Behälter seit langem und fortgesetzt mit einem Sieb oder einer Lochplatte verschlossen. (US 5 532 102 A, DE 24 36 431 A, WO 91 04 348 A). Durch die Löcher wurde eine gleichmäßige definierte Beschichtung gefördert. Ein Zusetzen der Löcher wurde dadurch vermieden, daß die Lochplatte geheizt wurde, um dort kondensierendes Material zu verdampfen. Die DE 24 36 431 A arbeitet mit einer gegenüber dem Materialbehälter um 5 bis 30°C erhöhten Temperatur der Lochplatte, die vorteilhaft auch Materialspritzer zurückhält. Nach der US 5 532 102 A wird am Anfang der Beschichtung die Lochplatte auf eine signifikant höhere Temperatur als der Materialbehälter gebracht und dann auf die des Behälters oder etwas darüber abgesenkt. Die Löcher in der Abdeckung sind an den Randbereichen größer, um eine gleichmäßigere Beschichtung mit dem durch die Löcher hindurch tretenden Dampf zu erzielen. Die WO 91 04 348 A verwendet über die gesamte Höhe eines Verdampfungstiegels verteilt Heizvorrichtungen, um eine möglichst gleichmäßige Wärmeverteilung zu erzielen. Die gleichmäßige Wärmeverteilung wird durch eine Lochabdeckung des Tiegels weiter gefördert, die gegenüber dem Tiegel auf eine erhöhte Temperatur erhitzt wird und auch Materialspratzer und dergleichen zurückhalten soll. Die DE 26 53 909 A zeigt eine thermische Verdampferquelle für großflächige Substrate, welche einen senkrecht stehenden gelochten Deckel aufweist. Die Fläche der Austrittsöffnungen soll weniger als 30%, bevorzugt 15% der gesamten Deckelfläche betragen. Kondensationen am Deckel werden dadurch verhindert, daß das Deckelmaterial sich im Beschichtungsbetrieb aufheizt. Es können so reproduzierbare Dampfströme z.B. von verdampftem Silber erzielt werden.

Bevorzugte Weiterbildungen der Erfindung sind in den Unteransprüchen definiert.

Im folgenden wird die Erfindung anhand der Zeichnungen näher erläutert. Es zeigen
Figur 1 eine schematische geschnittene Darstellung eines Ausführungsbeispiels der erfindungsgemäßen Vorrichtung für eine horizontale Beschichtung,
Figur 2 eine perspektivische Explosionsansicht eines Materialbehälters, einer Abdekkung und eines geheizten Rahmens der Figur 1 und
Figur 3 eine Ansicht auf einen Materialbehälter mit Abdeckung und geheiztem Rahmen für eine vertikale Beschichtung.

Die erfindungsgemäße Vorrichtung eignet sie sich auch zur Herstellung anderer photovoltaischer Elemente wie CIS Module z.B. mit einer aufzubringenden CdS-Beschichtung.

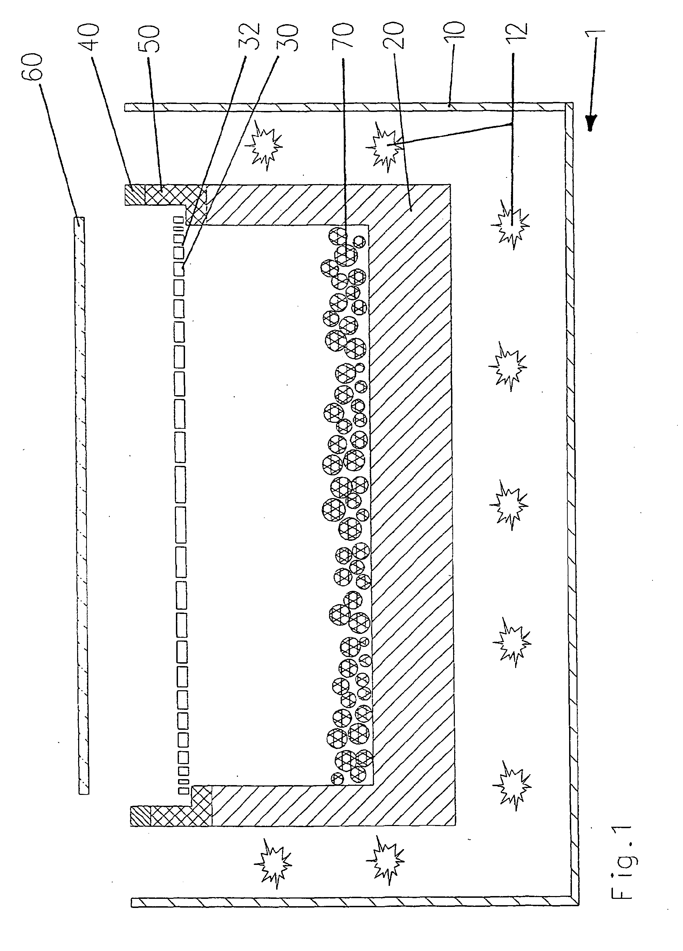

Die in Figur 1 gezeigte Vorrichtung 1 unterscheidet sich von den bisherigen CSS-Beschichtungsvorrichtungen prinzipiell dadurch, daß die Kleindistanz (dose space) für die Beschichtung nicht mehr zwischen dem zu sublimierenden Material (CdS bzw. CdTe) in Form eines Granulats, einer polykristallinen Scheibe oder dergleichen und dem Substrat definiert ist (z.B. EP 92 116 254.1). In einer nicht dargestellten Vakuumkammer sind mehrere Vorrichtungen 1 hintereinander angeordnet. Die Vakuumkammer wird mittels mechanischer Pumpen auf einem Restgasdruck von 10⁻⁴ bis 10 mbar, vorzugsweise 10⁻² mbar, gehalten und die Substratbeschichtung erfolgt im Ausführungsbeispiel in diesem Restgas. Es kann jedoch wahlweise auch mit inerten Gasen wie Stickstoff, Helium, Argon und dergleichen gespült werden. Die Substrate 60 werden in einem kontinuierlichen Durchlauf über Ein- und Austrittsschleusen in die Vakuumkammer eingebracht und über die Vorrichtungen 1 hinweg bewegt. Zwischen den Vorrichtungen 1 befinden sich Rollen als Trägereinrichtung, auf denen die Substrate 60 bei ihrer Bewegung über die Vorrichtungen laufen. Hierbei sind die flächigen Substrate 60 mit ihrer zu beschichtenden Seite nach unten gerichtet. In Figur 1 werden die Substrate 60 senkrecht zur Papierebene geführt.

Die Vorrichtung 1 umfaßt eine im Querschnitt rechteckige Wärmeabschirmung 10 aus Graphit (beispielsweise faserverstärktem Graphit), oder anderen gegen das zu verdampfende Material inerten Materialien wie Tantal oder Molybdän. In der Wärmeabschirmung ist eine rechteckige Wanne 20 angeordnet. Diese besteht im Ausführungsbeispiel aus Graphit.

Die im Vergleich zu den bisherigen Graphittiegeln großvolumige Wanne 20 weist eine großflächige Öffnung 22 nach oben auf und eine ausreichende Höhe, um einen Materialvorrat 70 (hier CdTe-Granulat) für eine möglichst große Standzeit aufnehmen zu können. Im Ausführungsbeispiel hat die rechteckige Öffnung 22 Abmessungen von 250 mal 700 cm und die Wanne kann bei einer Tiefe von 200 cm etwa 80 kg CdTe aufnehmen. Mit einer Wanne können Standzeiten von mehreren Tagen erzielt werden. Mit mehreren in der Substratvorschubrichtung hintereinander angeordneten Wannen kann die Standzeit ohne weiteres auf eine Woche gesteigert werden.

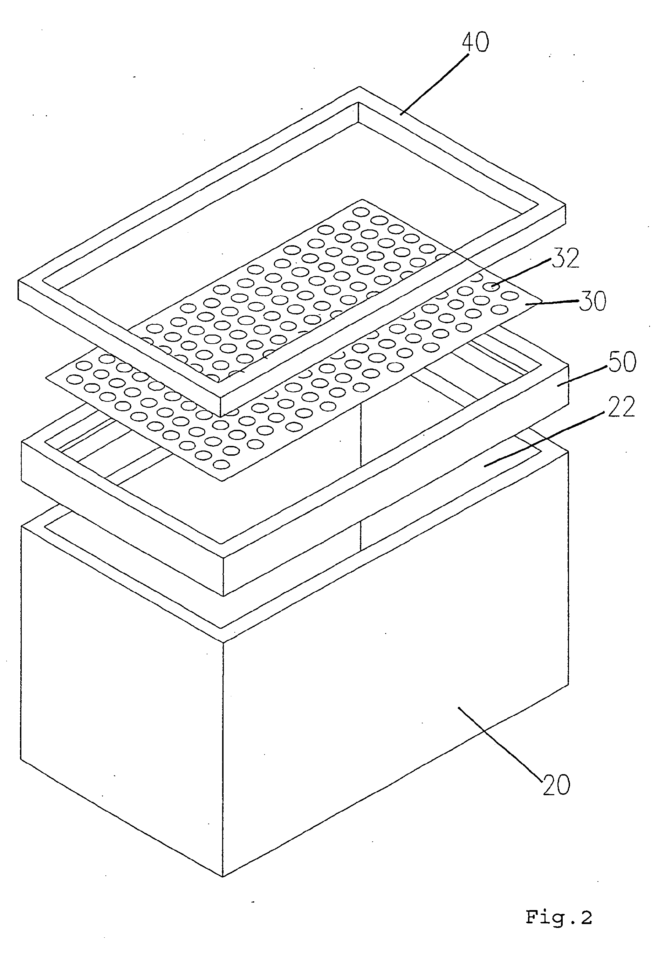

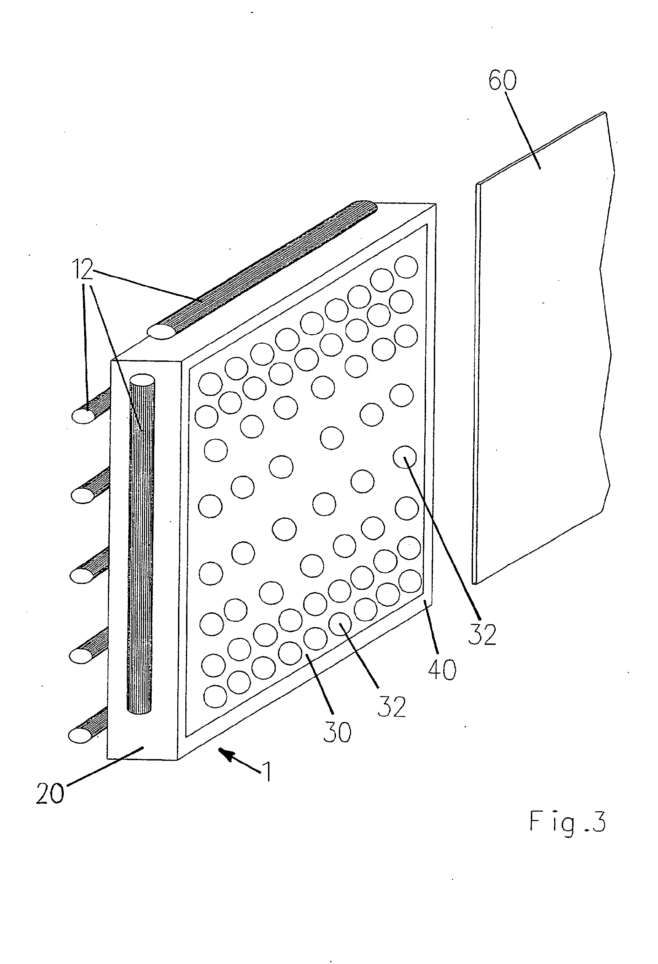

In den oberen Wannenrand ist gemäß Figur 2 eine Lochplatte 30 aus Graphit (SIGRA-BOND (eingetragene Marke) der SGL Carbon Group) eingelassen, die jedoch auch andere gegen das Beschichtungsmaterial inerte Materialien aufweisen kann, wie sie oben erwähnt sind. Dabei sitzt die Platte 30 nicht direkt auf dem Wannenrand, sondern in einem isolierenden Keramikhalter 50. Dieser ist im Ausführungsbeispiel im Querschnitt L-förmig und im Wannenrand über nicht dargestellte Stifte verankert. Die Platte 30 liegt in der gezeigten Weise im Keramikhalter 50, der beispielsweise aus Aluminiumoxid besteht. Die Durchtrittslöcher 32 der Platte 30 weisen im Ausführungsbeispiel im mittleren Bereich einen Durchmesser von etwa zwei mm auf. Die Durchtrittslöcher 32 sind einerseits so groß, daß sie den Durchtritt des verdampften (hier über Sublimation) Materials nicht merklich behindern, und andererseits klein genug, daß sie die gewünschte Entkopplung vom Materialvorrat nicht schmälern. Dies gelingt, wenn man, wie dargestellt, zahlreiche Löcher von etwa ein bis vier mm Durchmesser in dichtem Abstand gleichmäßig verteilt anordnet, wie insbesondere aus Figur 3 hervorgeht. Im Ausführungsbeispiel sind die Löcher 32 in einem kubisch flächenzentrierten Lochmuster von 8 x 8 mm angeordnet. Damit ergibt sich ein das sublimierte Material durchlassender Flächenanteil der Platte 30 von etwa 10%. Am Substratrand sind die Löcher größer und/oder dichter ausgebildet, um über die gesamte Plattenbreite eine gleichmäßig Beschichtung zu erzielen. (Ein Substratpunkt wird nicht nur vom direkt unter ihm liegenden Loch, sondern auch von den umgebenden Löchern beaufschlagt, weshalb die Beaufschlagung am Randbereich bei unveränderter Lochstruktur geringer wäre).

Die Verwendung einer Platte hat gegenüber prinzipiell möglichen Ausführungen als Drahtgeflecht aus elektrisch und wärmeleitendem Material die Vorteile, daß der prozentuale Durchlaßbereich mit einer einzigen Platte leicht auf geeignete Werte zwischen etwa 5 und 25 % einstellbar ist. Zudem kann die Durchlässigkeit durch das Lochmuster örtlich gezielt vorgegeben werden. Bei einem Geflecht ist die Durchlässigkeit in der Regel für die gewünschte Entkopplung zu hoch, so daß mit zwei oder mehr übereinander angeordneten Geflechten gearbeitet werden müßte.

Das Material Graphit für die Platte bietet den Vorteil einer guten elektrischen Leitfähigkeit und auch Wärmeleitfähigkeit und hat als korrosionsbeständiges Material den Vorteil, nicht mit den Dampfpartikeln zu reagieren. Auch kann die Graphitplatte 30 direkt geheizt werden. Hierzu ist die Platte direkt an eine separate ohmsche Heizung angeschlossen.

Der (in der Zeichnung übertrieben groß dargestellte) Abstand A zwischen dem Substrat 60 und der Lochplatte 30 wird über nicht dargestellte Führungs- und Abstandsmittel auf 2 bis 50 mm eingestellt. Im Ausführungsbeispiel beträgt der Abstand etwa 10 mm.

Ein heizbarer Rahmen 40 ebenfalls aus Graphit sitzt gegenüber der Platte 30 erhöht. Auch hier sind im Prinzip die weiter oben dargelegten Materialalternativen wie für die Platte 30 und die Abschirmung 10 sowie auch die Wanne 20 möglich. Der Rahmen 40 ist in der dargestellten Weise an der Oberseite des Keramikhalters 50 befestigt und wiederum durch direkte ohmsche Heizung unabhängig von der Platte 30 und der Wanne 20 heizbar. Starre elektrische Zuleitungen können zur Fixierung des leichten Rahmens 40 genutzt werden. Der Keramikhalter 50 ist im Ausführungsbeispiel so ausgelegt, daß er als einstükkiges Teil sowohl die elektrische Isolierung der Wanne 20 gegenüber der Platte 30 als auch der Platte 30 gegenüber dem Rahmen 40 bewirkt, so daß für den Rahmen 40 und die Platte 30 separate Heizkreise möglich sind. Der Fachmann kann hier jedoch zahlreiche andere Isolationsmaßnahmen wählen.

Die Wanne 20 wird ebenfalls unabhängig geheizt, im Ausführungsbeispiel mittels Heizlampen 12 in Form von Halogenlampen. Prinzipiell wird für den Beschichtungsbetrieb so geheizt, daß die Lochplatte 30 um einige Grad Celsius, vorzugsweise etwa 2 bis 5 °C heißer ist als die Wanne 20, die im Ausführungsbeispiel gegenüber dem Substrat 60, das auf eine Temperatur von etwa 500 °C vorgeheizt ist, auf etwa 750 °C erhitzt wird. Das Substrat hält bei seiner Hinwegbewegung über die Vorrichtung 1 infolge der Erwärmung durch die heißen Vorrichtungselemente 12, 20 und 30 seine Vorheiztemperatur von etwa 500 °C bei. Der Rahmen 40 wiederum wird um einige Grad Celsius, hier vorzugsweise wieder 2 bis 5 °C höher aufgeheizt als die Lochplatte 30. Die angegebenen Temperaturbereiche haben sich bei den speziellen Beschichtungsparametern als geeignet erwiesen. Dies schließt jedoch nicht aus, daß die Temperaturunterschiede auch geringer oder höher sein können. Im allgemeinen wird allerdings ein Temperaturunterschied von weniger als 2 °C zwischen Lochplatte 30 und Wanne 20 sowie Platte 30 und Rahmen 40 nicht für die im folgenden dargelegten Wirkungen ausreichen. Größere Temperaturunterschiede über 10 °C sind prinzipiell möglich, allerdings sollten sich durch die Temperaturgradienten die jeweiligen Beschichtungsbedingungen nicht ändern, d.h. daß die Temperaturdifferenz zwischen der als physikalische Beschichtungsquelle wirkenden Lochplatte 30 und dem Substrat 60 die jeweiligen Beschichtungsbedingungen erfüllt und außerdem eine optimale Sublimationstemperatur im Materialvorrat eingestellt werden kann.

Wie bereits dargelegt, sorgt der Temperaturunterschied zwischen der Lochplatte 30 und der Wanne 20 dafür, daß die Beschichtungsbedingungen unabhängig vom Füllstand der Wanne 20 sind und z.B. Änderungen der Beschichtungsratenverteilung durch füllstandsbedingte Abschattungseffekte nicht kompensiert werden müssen. Bei einer Beschichtungsrate von etwa 10 pm/Minute kann mit der dargelegten Anordnung bei fortlaufender Beschichtung von etwa 0,7 m² großen Substraten eine Woche lang unterbrechungsfrei gearbeitet werden. Die örtliche Verteilung der Beschichtungsrate kann im übrigen durch die Ausbildung des Lochmusters in der Lochplatte 30 eingestellt werden, so daß durch Austausch der Platte die Beschichtungsratenverteilung wählbar ist. Mit anderen Worten ist die Beschichtungsratenverteilung von der aus geheizter Wanne und Materialvorrat bestehenden Quelle entkoppelt.

Der Heizrahmen 40 bietet den Vorteil, daß durch seine erhöhte Temperatur der Materialverlust am Rand der nach oben offenen Wanne 20 bis zu 80% verringert werden kann. Auch werden unerwünschte Kondensationseffekte in diesem sonst kälteren Randbereich verhindert, die ebenfalls die Schichtqualität am Substratrand beeinträchtigen könnten.

Ein weiterer Vorteil, den die erfindungsgemäße Vorrichtung bietet, kommt in Figur 3 zum Ausdruck, in der die Lochplatte 30 vor der Öffnung 22 der nun seitlich offenen Wanne 20 senkrecht steht. Innerhalb der Wanne 20 sind darüber hinaus z.B. fächerartige Aufteilungen vorgenommen und zusätzliche Lochplatten vorgesehen, um eine Gleichverteilung des Beschichtungsmaterials zu erzielen. Wegen der erfindungsgemäßen Entkoppelung ist es allerdings auch nicht ausgeschlossen, in einer gemäß Figur 3 senkrecht stehenden Vorrichtung statt der Wanne einen Behälter für den Materialvorrat vorzusehen, dessen von der Lochplatte 30 abgedeckte Öffnung sich an eine Behälterseitenwand anschließt, in deren Bereich ein größerer Materialvorrat liegt. Es können auch mehrere derartiger Behälter zu einer einzigen großflächigen Beschichtungsquelle übereinander stapelt werden.

Im Ausführungsbeispiel wurde zur Abdeckung der Öffnung der Wanne 20 eine Platte eingesetzt. Diese ebene Struktur ist für die üblichen Beschichtungsaufgaben auch erforderlich. Es ist jedoch denkbar, wenn z.B. unterschiedliche Beschichtungsbedingungen über das Substrat hinweg eingestellt werden sollen, auch beispielsweise eine gewölbte Struktur mit Durchgangslöchern als Abdeckung zu verwenden. Auch muß das Substrat nicht immer plan sein. Bei nicht planen Substraten kann zudem durch die Veränderung des Lochmusters der Lochplatte der unterschiedliche Abstand zwischen Lochplatte und Beschichtungsfläche ausgeglichen werden.

Im Fall von zu Partikelemission neigendem Verdampfungsmaterial können statt einer auch beispielsweise zwei leicht beabstandete Lochplatten mit zueinander versetztem Lochmuster eingesetzt werden. Auf diese Weise wird verhindert, daß vom Verdampfungsmaterial abgeplatzte Partikel als Spratzer durch ein Loch der Platte bis zum Substrat gelangen. Mit den beiden Platten wird durch den Versatz des Lochmusters eine optische Abschirmung erzielt.

## Patentansprüche

1. Vorrichtung zur Beschichtung von Substraten mit CdS- und CdTe-Schichten durch Aufdampfen im CSS-Verfahren (Close Spaced Sublimation-Verfahren), aufweisend einen geheizten Behälter (20) für einen Vorrat (70) an zu sublimierendem Material in Form von CdS und CdTe und eine Trägereinrichtung, die das Substrat (60) mit seiner zu beschichtenden Seite auf eine Öffnung (22) des Behälters gerichtet hält,
wobei die Behälteröffnung (22) mit einer zahlreiche Durchtrittsöffnungen (32) für das sublimierte Material aufweisenden Abdeckung (30) versehen ist, die den Materialvorrat (70) vom Substrat (60) trennt und dafür sorgt, dass die im CSS-Verfahren einzustellende Kleindistanz nicht mehr zwischen dem Material und dem Substrat definiert ist, indem diese Abdeckung (30) infolge einer Aufheizung auf eine höhere Temperatur als die des Behälters (20) als Sublimationsquelle für das Substrat (60) wirkt, **dadurch gekennzeichnet, dass** Abstandsmittel zur Einstellung der Distanz zwischen dem Substrat (60) und der als physikalische Beschichtungsquelle wirkenden Abdeckung (30) vorgesehen sind und dass die Abdeckung (30) auf ihrer dem Substrat (60) zugewandten Seite von einem geheizten Rahmen (40) umgeben ist, der auf einer höheren Temperatur als die der Abdeckung gehalten ist.

2. Vorrichtung nach Anspruch 1, **dadurch gekennzeichnet, dass** die Abdeckung eine Lochplatte (30) ist.

3. Vorrichtung nach Anspruch 2, **dadurch gekennzeichnet, dass** das Lochmuster über die Lochplatte (30) hinweg unterschiedlich vorgebbar ist und dass speziell im Randbereich die Löcher dichter und/oder größer vorgesehen sind.

4. Vorrichtung nach einem der vorhergehenden Ansprüche, **dadurch gekennzeichnet, dass** die Abdeckung (30) aus einem elektrisch leitfähigen Material, vorzugsweise Graphit besteht.

5. Vorrichtung nach Anspruch 1, **dadurch gekennzeichnet, dass** der Behälter (20), die Platte (30) und der Rahmen (40) jeweils elektrisch gegeneinander isoliert sind und die Platte (30) und der Rahmen (40) jeweils an eine ohmsche Heizung angeschlossen sind.

6. Vorrichtung nach einem der vorhergehenden Ansprüche, **dadurch gekennzeichnet, dass** die Abdeckung (30) für eine senkrechte Substratbeschichtung in einer Seitenöffnung des Behälters (20) angeordnet ist.

7. Vorrichtung nach Anspruch 6, **dadurch gekennzeichnet, dass** im Behälter (20) Mittel zum Zurückhalten des Materials vorgesehen sind.

8. Vorrichtung nach einem der vorhergehenden Ansprüche, **dadurch gekennzeichnet, dass** die Vorrichtung mit einer Graphitwanne (20) als der Behälter ausgelegt ist.

9. Vorrichtung nach einem der vorhergehenden Ansprüche,
**dadurch gekennzeichnet, dass** die Distanz auf Werte zwischen 2 bis 50 mm einstellbar ist.

10. Verfahren zur Beschichtung von Substraten mit CdS- und CdTe-Schichten durch Aufdampfen im CSS-Verfahren (Close Spaced Sublimation-Verfahren) unter Verwendung einer Vorrichtung, die einen geheizten Behälter (20) für einen Vorrat (70) an zu sublimierendem Material in Form von CdS und CdTe und eine Trägereinrichtung aufweist, die das Substrat (60) mit seiner zu beschichtenden Seite auf eine Öffnung (22) des Behälters gerichtet hält,
wobei die Behälteröffnung (22) mit einer zahlreiche Durchtrittsöffnungen (32) für das sublimierte Material aufweisenden Abdeckung (30) versehen ist, die den Materialvorrat (70) vom Substrat (60) trennt und dafür sorgt, dass die im CSS-Verfahren einzustellende Kleindistanz nicht mehr zwischen dem Material und dem Substrat definiert ist, indem diese Abdeckung (30) infolge einer Aufheizung auf eine höhere Temperatur als die des Behälters (20) als Sublimationsquelle für das Substrat (60) wirkt, wobei Abstandsmittel zur Einstellung der Distanz zwischen dem Substrat (60) und der als physikalische Beschichtungsquelle wirkenden Abdeckung (30) vorgesehen sind, und die Abdeckung (30) auf ihrer dem Substrat (60) zugewandten Seite von einem geheizten Rahmen (40) umgeben ist, der auf einer höheren Temperatur als die der Abdeckung gehalten ist.

## Claims

1. Apparatus for coating substrates with CdS and CdTe layers by vapour deposition in the CSS process (close spaced sublimation process), having a heated container (20) for a supply (70) of material to be sublimed in the form of CdS and CdTe and a carrier device which holds the substrate (60) oriented with its side to be coated towards an opening (22) of the container, the container opening (22) being provided with a cover (30) having numerous passage openings (32) for the sublimed material, which separates the material supply (70) from the substrate (60) and ensures that the small distance to be set in the CSS process is no longer defined between the material and the substrate, by this cover (30) acting as a sublimation source for the substrate (60) as a result of heating to a higher temperature than that of the container (20), **characterized in that** spacer means are provided for adjusting the distance between the substrate (60) and the cover (30) acting as a physical coating source, and **in that**, on its side facing the substrate (60), the cover (30) is surrounded by a heated frame (40), which is kept at a higher temperature than that of the cover.

2. Apparatus according to Claim 1, **characterized in that** the cover is a perforated plate (30).

3. Apparatus according to Claim 2, **characterized in that** the hole pattern over the perforated plate (30) can be predefined differently and that the holes are provided more densely and/or to be larger specifically in the edge region.

4. Apparatus according to one of the preceding claims, **characterized in that** the cover (30) consists of an electrically conductive material, preferably graphite.

5. Apparatus according to Claim 1, **characterized in that** the container (20), the plate (30) and the frame (40) are in each case insulated electrically from one another, and the plate (30) and the frame (40) are in each case connected to a non-reactive heater.

6. Apparatus according to one of the preceding claims, **characterized in that**, for vertical substrate coating, the cover (30) is arranged in a side opening of the container (20).

7. Apparatus according to Claim 6, **characterized in that** means for retaining the material are provided in the container (20).

8. Apparatus according to one of the preceding claims, **characterized in that** the apparatus is designed with a graphite trough (20) as the container.

9. Apparatus according to one of the preceding claims, **characterized in that** the distance can be adjusted to values between 2 and 50 mm.

10. Process for coating substrates with CdS and CdTe layers by vapour deposition in the CSS process (close spaced sublimation process) by using an apparatus which has a heated container (20) for a supply (70) of material to be sublimed in the form of CdS and CdTe and a carrier device which holds the substrate (60) oriented with its side to be coated towards an opening (22) of the container, the container opening (22) being provided with a cover (30) having numerous passage openings (32) for the sublimed material, which separates the material supply (70) from the substrate (60) and ensures that the small distance to be set in the CSS process is no longer defined between the material and the substrate, by this cover (30) acting as a sublimation source for the substrate (60) as a result of heating to a higher temperature than that of the container (20), spacer means being provided for adjusting the distance between the substrate (60) and the cover (30) acting as a physical coating source, and, on its side facing the substrate (60), the cover (30) being surrounded by a heated frame (40), which is kept at a higher temperature than that of the cover.

## Revendications

1. Dispositif de revêtement de substrats comprenant des couches de CdS et CdTe par métallisation sous vide au cours d'un procédé CSS (Sublimation à Courte Distance), comprenant un récipient chauffé (20) pour une réserve (70) de matériau à sublimer sous forme de CdS et de CdTe et un système de support, qui maintient le substrat (60) avec sa face à revêtir orienté vers une ouverture (22) du récipient,
l'ouverture de récipient (22) étant pourvue d'une couverture (30) comprenant de nombreuses ouvertures de passage (32) pour le matériau sublimé, laquelle sépare la réserve de matériau (70) du substrat (60) et veille à ce que la petite distance à régler au cours du procédé CSS ne soit plus définie entre le matériau et le substrat, en ce que cette couverture (30) à la suite d'un chauffage agit à une température plus élevée que celle du récipient (20) comme source de sublimation pour le substrat (60), **caractérisée en ce que** des moyens d'écartement destinés à régler la distance entre le substrat (60) et la couverture (30) agissant comme source de revêtement physique sont prévus et **en ce que** la couverture (30) est entourée sur sa face tournée vers le substrat (60) par un cadre chauffé (40), qui est maintenu à une température plus élevée que celle de la couverture.

2. Dispositif selon la revendication 1, **caractérisé en ce que** la couverture est un plateau perforé (30).

3. Dispositif selon la revendication 2, **caractérisé en ce que** le modèle de trou peut être prédéfini de manière différente sur le plateau perforé (30) et **en ce que** en particulier les trous sont prévus en étant plus denses et/ou plus grands dans la zone de bord.

4. Dispositif selon l'une quelconque des revendications précédentes, **caractérisé en ce que** la couverture (30) est constituée d'un matériau électriquement conducteur, de préférence le graphite.

5. Dispositif selon la revendication 1, **caractérisé en ce que** le récipient (20), le plateau (30) et le cadre (40) sont respectivement électriquement isolés les uns des autres et le plateau (30) et le cadre (40) sont raccordés respectivement à un chauffage résistif.

6. Dispositif selon l'une quelconque des revendications précédentes, **caractérisé en ce que** la couverture (30) pour un revêtement vertical de substrat est disposée dans une ouverture latérale du récipient (20).

7. Dispositif selon la revendication 6, **caractérisé en ce que** des moyens de retenue du matériau sont prévus dans le récipient (20).

8. Dispositif selon l'une quelconque des revendications précédentes, **caractérisé en ce que** le dispositif comporte en tant que récipient une cuve en graphite (20).

9. Dispositif selon l'une quelconque des revendications précédentes, **caractérisé en ce que** la distance peut être réglée selon des valeurs comprises entre 2 et 50 mm.

10. Procédé de revêtement de substrats comprenant des couches de CdS et CdTe par métallisation sous vide au cours d'un procédé CSS (Sublimation à Courte Distance) en utilisant un dispositif qui comprend un récipient chauffé (20) pour une réserve (70) de matériau à sublimer sous forme de CdS et de CdTe et un système de support, qui maintient le substrat (60) avec sa face à revêtir orientée vers une ouverture (22) du récipient,
l'ouverture de récipient (22) étant pourvue d'une couverture (30) comprenant de nombreuses ouvertures de passage (32) pour le matériau sublimé, laquelle sépare la réserve de matériau (70) du substrat (60) et veille à ce que la petite distance à régler au cours du procédé CSS ne soit plus définie entre le matériau et le substrat, en ce que cette couverture (30) à la suite d'un chauffage à une température plus élevée que celle du récipient (20) agit comme source de sublimation pour le substrat (60), des moyens d'écartement destinés à régler la distance entre le substrat (60) et la couverture (30) agissant comme source de revêtement physique sont prévus, et la couverture (30) étant entourée sur sa face tournée vers le substrat (60) d'un cadre chauffé (40), qui est maintenu à une température plus élevée que celle de la couverture.
